# EUROPEAN PATENT APPLICATION

(11) **EP 4 524 703 A1**
(43) Date of publication of application: **19.03.2025**
(21) Application number: 24200417.4
(22) Date of filing: 13.09.2024
(51) Int. Cl.: G06F 3/0482, G06F 3/0483, G06F 30/12, G06T 17/20, G06T 19/00, G06F 111/16

(54) **TABBED USER INTERFACE FOR LIGHTWEIGHT VIEWER**

(30) Priority: 15.09.2023 US 202318467807
(71) Applicant: RTX Corporation, Farmington, CT 06032 (US)
(72) Inventor: DOLL, Stephen, Farmington, 06032 (US); BROWN, Michael P., Farmington, 06032 (US)
(74) Representative: Dehns

(57) **Abstract**

A user interface for a lightweight viewer may include, among other things, a viewing window operable to display geometry established by one or more geometric objects of a tessellated model and an information window established by a plurality of content objects of the tessellated model. The content objects are associated with respective layers of the tessellated model that occupy a common display region. The content objects are operable to selectively display information associated with the tessellated model in response to user interaction with the respective content object such that the respective layer is activated but a remainder of the layers are deactivated in the common display region. A method of establishing a tessellated model is also disclosed.

## Description

### BACKGROUND

This disclosure relates to modeling and interaction with the design of various components.

Computer-Aided Design (CAD) systems are known and may be utilized to generate two-dimensional and three-dimensional (3D) models of various components. The associated CAD files may be relatively large, which may impede transfer to other computing systems. A lightweight, tessellated representation of the CAD model may be generated and stored within a file that excludes the original CAD model. The file may be saved in a Portable Document Format (PDF) or another file format. A lightweight viewer may be utilized to view the lightweight representation.

### SUMMARY

A user interface for a lightweight viewer according to the present disclosure includes a viewing window operable to display geometry established by one or more geometric objects of a tessellated model. An information window is established by a plurality of content objects of the tessellated model. The content objects associated with respective layers of the tessellated model that occupy a common display region are operable to selectively display information associated with the tessellated model in response to user interaction with the respective content object such that the respective layer is activated but a remainder of the layers are deactivated in the common display region.

Optionally, the common display region is spaced apart from, but concurrently displayed with, the viewing window in response to opening the tessellated model.

Optionally, the information window is established by a plurality of tab objects of the tessellated model, the tab objects are arranged in an array to depict a tabbed interface, the tab objects are associated with respective ones of the content objects, and each of the tab objects is operable to selectively activate the layer of the respective content object and deactivate the remainder of the layers in response to user interaction with the respective tab object.

Optionally, the array is directly adjacent to the common display region.

Optionally, one or more of the content objects is associated with a scroll bar object adjacent to the common display region.

Optionally, the scroll bar object is operable to cause a visible portion of the activated layer to vary in response to user interaction.

Optionally, the information includes one or more statements, the content objects are associated with a counter object, and the counter object is operable to indicate a quantity of the one or more statements assigned to the respective content object.

Optionally, the user interface includes a navigation window operable to display one or more view objects, each of the one or more view objects is associated with a respective depiction of the one or more geometric objects, wherein the viewing window is operable to display the depiction in response to selection of the respective view object, and one or more of the content objects is dynamically linked to one or more of the view objects such that the information assigned to the respective content object updates in response to selection of the respective view object.

Optionally, the tessellated model excludes any CAD model associated with the geometry.

A system for generating a tessellated model according to the present disclosure includes a computing device that has one or more processors coupled to memory. The computing device is operable to execute a modeling environment. The modeling environment is operable to access a computer-aided design (CAD) model associated with geometry, generate one or more geometric objects that establish a tessellation of the geometry, generate a plurality of content objects, and generate a tessellated model including the one or more geometric objects and the content objects. The one or more geometric objects are operable to display the tessellation of the geometry in a viewing window of a user interface. The content objects are operable to establish an information window of the user interface. The content objects are associated with respective layers of the tessellated model that occupy a common display region of the user interface. The content objects are operable to selectively display information associated with the tessellated model in the common display region.

Optionally, the content objects are operable to establish the information window such that the common display region is spaced apart from, but concurrently displayed with, the viewing window in response to opening the tessellated model in a lightweight viewer.

Optionally, the modeling environment is operable to generate a plurality of tab objects, the tessellated model includes the tab objects, the tab objects are operable to depict a tabbed interface in the information window, the tab objects are associated with respective ones of the content objects, each of the tab objects are operable to selectively activate the layer of the respective content object and deactivate a remainder of the layers in response to user interaction with the tab object.

Optionally, the modeling environment is operable to generate one or more view objects associated with a navigation window of the user interface, each of the one or more view objects is associated with a respective depiction of the one or more geometric objects, the viewing window is operable to display the depiction in response to user interaction with the respective view object and dynamically link one or more of the content objects to one or more of the view objects such that the information assigned to the one or more content objects updates in response to user interaction with the respective view object, and the tessellated model includes the one or more view objects.

Optionally, the modeling environment is operable to store the tessellated model in a file readable by a lightweight viewer, and the file excludes the CAD model.

Optionally, the modeling environment is operable to store code in the file that is operable to cause one or more functions associated with the tessellated model to execute in the lightweight viewer.

A method of establishing a tessellated model according to the present disclosure includes generating one or more geometric objects that establish a tessellation of geometry stored in a computer-aided design (CAD) model. The one or more geometric objects are operable to display the tessellation of the geometry in a viewing window of a user interface and generating a plurality of content objects. The content objects are operable to establish an information window of the user interface. The content objects are associated with respective layers that occupy a common display region of the user interface. The method includes assigning information associated with the geometry to the content objects. The content objects are operable to selectively display the respective information in the common display region. The method includes generating a tessellated model including the one or more geometric objects and the content objects.

The method optionally includes generating a plurality of tab objects, wherein the tab objects are operable to depict a tabbed interface in the information window, the tab objects are associated with respective ones of the content objects, each of the tab objects is operable to selectively activate the layer of the respective content object and deactivate a remainder of the layers in response to user interaction with the respective tab object, and the step of generating the tessellated model occurs such that the tessellated model includes the tab objects.

Optionally, the content objects are operable to establish the information window such that the common display region is spaced apart from, but concurrently displayed with, the viewing window.

The method optionally includes dynamically linking one or more of the content objects to one or more view objects such that the information assigned to the respective content object updates in response to user interaction with the respective view object. The one or more view objects are optionally associated with respective depictions of the one or more geometric objects in the viewing window.

Optionally, the method includes storing the tessellated model in at least one file that excludes the CAD model.

Optionally, the method includes displaying the tessellated model in a lightweight viewer.

Embodiments of the present disclosure may include any one or more of the individual features disclosed above and/or below alone or in any combination thereof.

### BRIEF DESCRIPTION OF THE DRAWINGS

Certain exemplary embodiments will now be described in greater detail by way of example only and with reference to the accompanying drawings in which:
Figure 1 discloses a modeling system.
Figure 2 discloses a graphical depiction of a tessellated model.
Figure 3 discloses an arrangement of a tessellated model.
Figure 4A discloses a graphical user interface for depicting geometry.
Figure 4B discloses selected portions of the user interface of Figure 4A.
Figure 5 discloses an arrangement of the user interface of Figure 4A.
Figure 6 discloses another arrangement of the user interface of Figure 4A.
Figure 7 discloses another depiction of the geometry in the user interface of Figure 4A.
Figure 8 discloses a method of generating a tessellated model.

Like reference numbers and designations in the various drawings indicate like elements.

### DETAILED DESCRIPTION

Display space in a model-based definition (MBD) lightweight viewer used to render a tessellated model may be limited. The geometric model may be associated with many requirements which may need to be presented to the user in a user interface. Showing all the information simultaneously may exceed the amount of display space that may be available in the user interface.

Disclosed are techniques for decluttering a user interface. The user interface may incorporate an interactive tabbed interface for displaying information relating to the geometric model. Application programming interface (API) functions may be used to create tabs of the tabbed interface. The API may not include the tabs, but it may support field objects configured to depict the tabs. The field objects may be utilized to establish the tabbed interface. The field objects may be assigned the same display area in the user interface. The code (e.g., script) to generate the tabbed interface may be embedded within a tessellated file. The tessellated file may be stored in a lightweight format, such as a Portable Document File (PDF) format. Accordingly, the lightweight viewer does not have to be programmed to support the tabbed interface and any lightweight viewer that supports the file format may access the model and tabbed interface. Information in the tabbed information area may be viewed on command.

The tabbed information area may be embedded in a display window of a lightweight viewer that may present information relating to the geometric model. Individual tabs when selected may present information relevant to that tab. The tabs may be associated with different layers in the same display area. The layers may be exposed on demand. Each tab may display a count of informational lines contained on the tab. A scroll bar may be utilized to view the informational lines. A single tab may be selectively visible at a time. The code (e.g., script) to generate the tabbed interface may be embedded within the same file associated with the tessellated geometry.

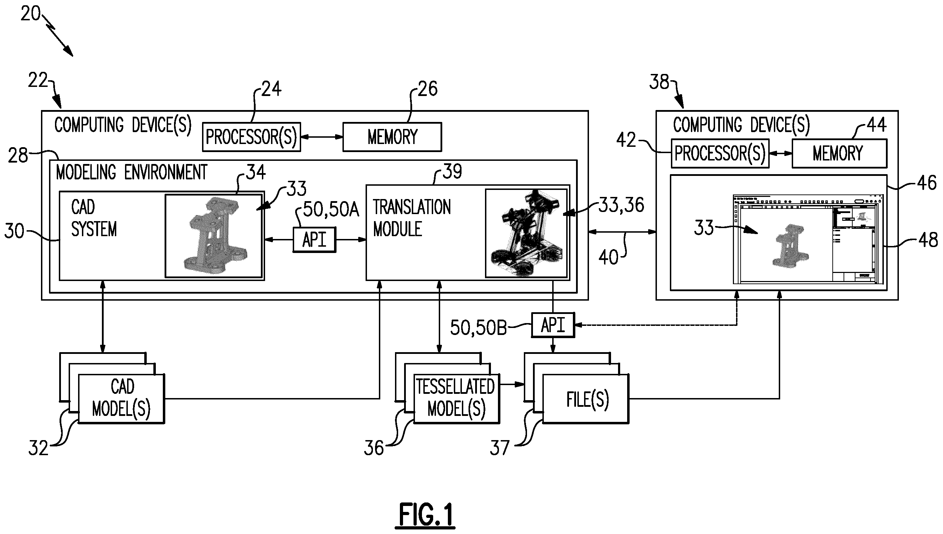

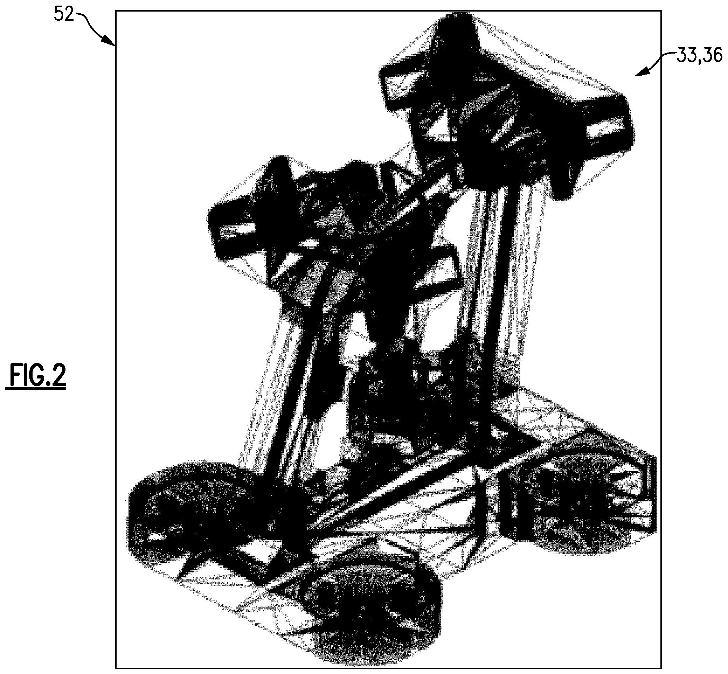

Figure 1 discloses a modeling system 20. The modeling system 20 may be operable to interact with one or more computer-aided design (CAD) models. The modeling system 20 may be operable to generate one or more tessellated models from the CAD model(s). The tessellated model may be relatively compact and may include a lesser amount of data compared to the CAD model. The tessellated model may represent CAD geometry as a set of facets (e.g., triangles) that may be patched together (see, e.g., Figure 2). Each of the facets may be defined by three respective points of a point cloud. The features disclosed herein may be incorporated into, or may otherwise be utilized with, a lightweight viewer. The tessellated models may be viewable in the lightweight viewer. For the purposes of this disclosure, a "lightweight viewer" is a software application suitable to view tessellated models. The lightweight viewer may be operable to view and interact with, but not edit, the tessellated model. Lightweight viewers may include a 3D PDF or HTML viewer or another viewer such as JT2Go operable to access tessellated models stored in a lightweight file format.

The modeling system 20 may include at least one computing device 22. The computing device 22 may include one or more processors 24 coupled to memory 26. The computing device 22 may be operable to execute a modeling environment (e.g., tool) 28. The modeling environment 28 may incorporate or may otherwise interface with a CAD system 30 (e.g., CATIA, AutoCAD, Solidworks, Siemens NX, etc.). The CAD system 30 and/or another portion of the modeling environment 28 may be operable to access one or more CAD models 32. Each of the CAD models 32 may be associated with geometry. The geometry may be associated with one or more virtual and/or physical components, assemblies and/or systems. The CAD system 30 may be operable to display one or more of the CAD models 32 in a user interface 34.

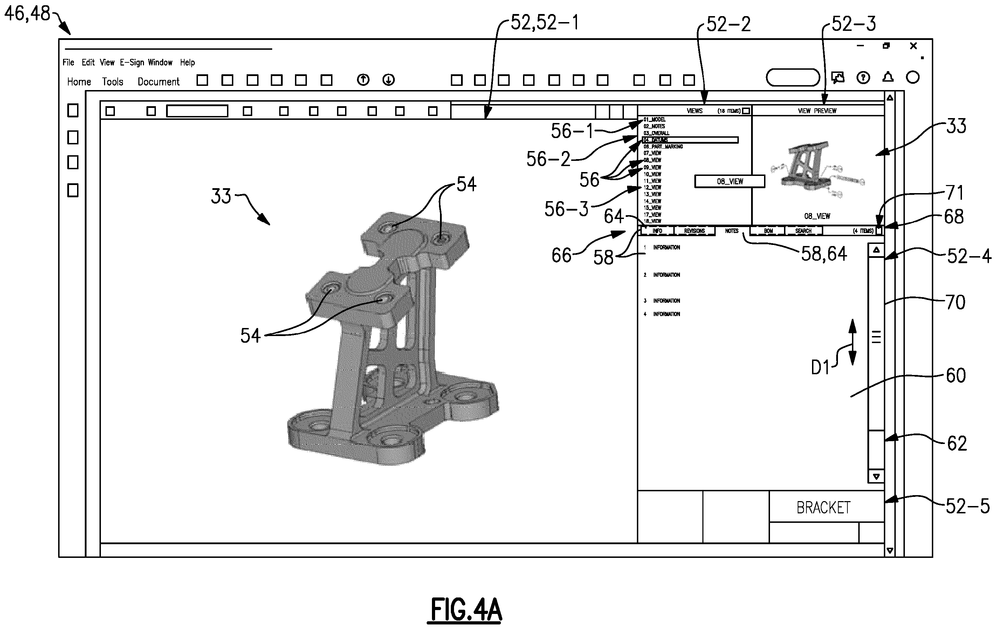

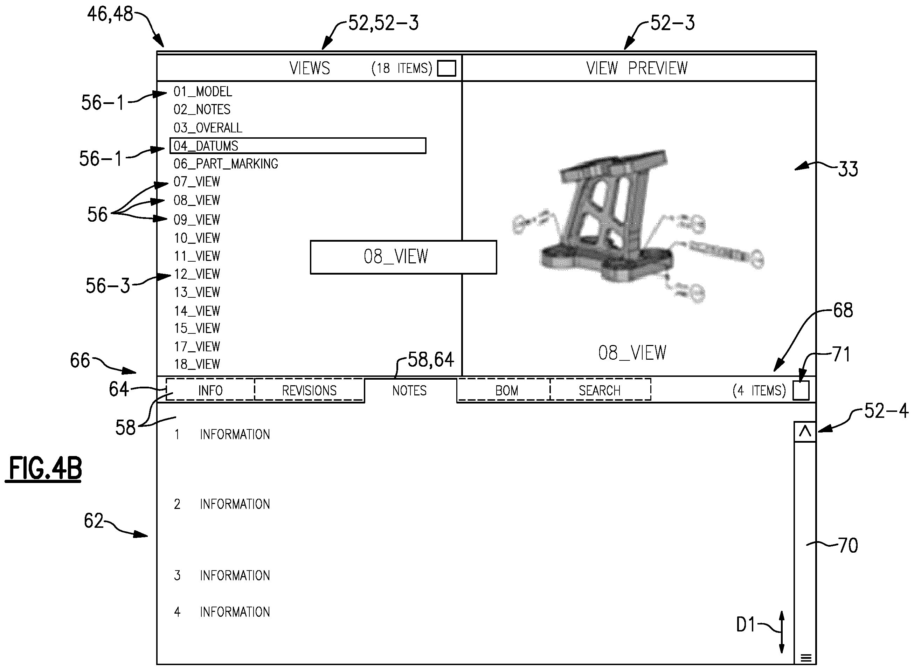

A user may desire to share or otherwise communicate information associated with the design to one or more other users, such as another member of a development team, a customer, or a supplier. The modeling environment 28 may be operable to generate one or more tessellated models 36, which may have a relatively lesser amount of information than the associated CAD model(s) 32 for communication to the other users. The tessellated model 36 may be stored in one or more lightweight files 37. The CAD model 32 and tessellated model 36 may be associated with geometry 33 (e.g., Figures 2 and 4A). The tessellated model 36 may exclude the exact CAD geometry and/or any CAD model 32 associated with the geometry 33.

Various users may access and review the tessellated models 36 in a lightweight viewer. Various lightweight viewers may be utilized, such as Adobe which may be operable to access PDF files. The lightweight viewer may be operable to access and view lightweight files containing tessellated models but not any files containing CAD models, including the exact CAD geometry. In other implementations, the modeling environment 28 may be operable to store the tessellated model 36 and the exact CAD geometry in the same file. Each of the tessellated models 36 may be associated with one or more respective CAD models 32 that store the exact CAD geometry and related information. Figure 2 discloses a graphical depiction of a tessellated model 36 according to an implementation. The specific geometry of the depicted tessellated model 36 is not intended to limit this disclosure.

The modeling environment 28 may be operable to access and display each of the tessellated models 36. In implementations, one or more (e.g., client) computing devices 38 may be operable to access the tessellated models 36. The computing devices 22, 38 may include one or more computer processors, memory, storage means, network devices, input and/or output devices, and/or interfaces. The computing devices 22, 38 may be operable to execute one or more software programs, including one or more portions of the modeling environment 28. The computing devices 22, 38 may be operable to communicate with one or more networks established by one or more computing devices. The memory may include UVPROM, EEPROM, FLASH, RAM, ROM, DVD, CD, a hard drive, or other computer readable medium which may store data and/or the functionality of this description. The computing devices 22, 38 may be a desktop computer, laptop computer, smart phone, tablet, or any other computer device. Input devices may include a keyboard, mouse, touchscreen, etc. The output devices may include a monitor, speakers, printers, etc. Each of the computing devices 38 may include one or more processors 42 coupled to memory 44. The computing device 38 may be coupled to the computing device 22 by connection(s) 40. The connection 40 may be a wired and/or wireless connection. The connection 40 may be established over one or more networks and/or other computing systems.

The processor 42 of the computing device 38 may be operable to execute a lightweight viewer 46. The lightweight viewer 46 may be a separate software application executable by the computing device 38 or may be a service provided by the computing device 22 which may be accessible by a thin client or browser over a network connection. The lightweight viewer 46 may be operable to access the tessellated models 36. The lightweight viewer 46 may be displayed in a display device. The lightweight viewer 46 may include a graphical user interface (GUI) 48 operable to display the tessellated model 36. The lightweight viewer 46 may be operable to read tessellated models 36 but not any CAD models 32, including CAD models 32 relating to geometry associated with the tessellated models 36.

Various techniques may be utilized to establish the tessellated models 36. The modeling environment 28 may be operable to generate one or more objects (e.g., elements), including any of the objects disclosed herein. In implementations, the objects may be field objects. The tessellated model 36 may include one or more field objects. The field objects and associated contents may be embedded within the tessellated model 36. The modeling environment 28 may include, or may otherwise interface with, one or more application programming interfaces (API) 50. In the implementation of Figure 1, the system 20 may include or otherwise interface with a first API 50A and a second API 50B. The functionality of the APIs 50A, 50B may be incorporated into a single API 50 or may be distributed between three or more APIs 50. The CAD system 30 and/or lightweight viewer 46 may be operable to interact with the respective CAD models 32 and tessellated models 36 according to the API 50. The lightweight viewer 46 may be configured to recognize objects, function calls, data structures, etc. specified in the API(s) 50. The API 50 may be utilized to establish one or more tessellated models 36. The API 50 may be utilized to convert the CAD models 32 to tessellated models 36. The modeling environment 28 may include a translation module 39 operable to establish tessellated models 36 and/or lightweight files 37. The translation module 39 may be operable to interact with the API 50B to establish (e.g., render) tessellated models 36. The translation module 39 may be operable to interact with the API 50B to establish lightweight files 37 including tessellated model(s) 36 in a format (e.g., data structure) supported by the API 50B and/or lightweight viewer 46. The API 50 may be utilized to assign various information, scripts and other data to one or more fields of the field objects. The field objects may be established according to data structure(s) specified in the API 50. The API 50 may provide the ability to associate scripts with objects of the tessellated model 36. The code (e.g., script) to generate the disclosed features and/or any code that causes any associated functions to occur in the lightweight viewer (e.g., in response to selection of the objects of the model 36) may be embedded within the same lightweight file 37 as the objects of the model 36 associated with the model geometry 33. The scripts and other code may be executed in response to user interaction and/or selection of the respective field object. The script may be specified according to JavaScript or another scripting language supported by the API 50. Storing the code that causes the function(s) associated with the objects and other features in the lightweight file 37 itself allows for the publisher to control the file presentation directly and does not require a special viewer.

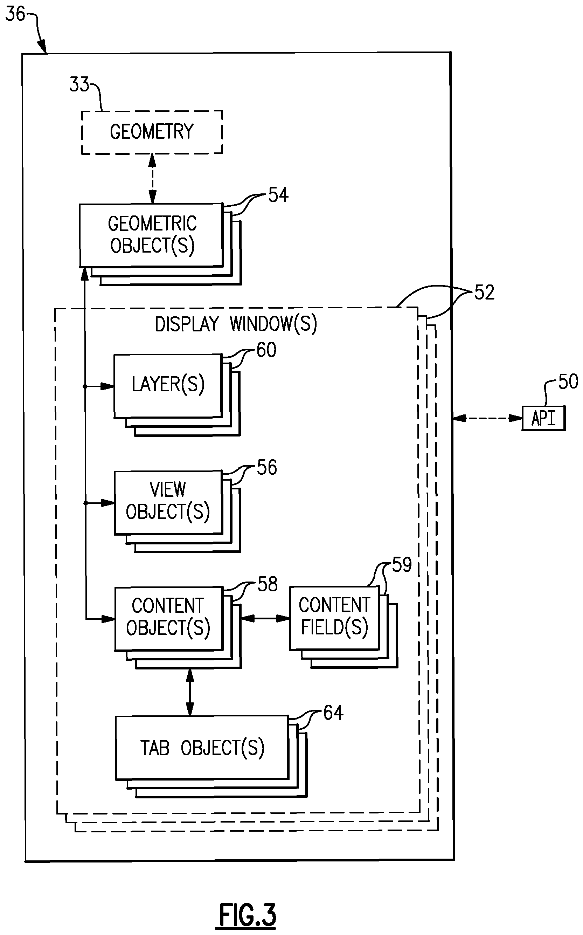

Figure 3 schematically illustrates a tessellated model 36 according to an implementation. The tessellated model 36 may include any of the objects and associated structures disclosed herein. The tessellated model 36 may be established with respect to one or more data structures specified in the API 50. Various techniques may be utilized to establish relationships between the various objects of the tessellated model 36, including one or more static and/or dynamic links which may be specified in field(s) of the field objects. The API 50 may be utilized to establish the objects and links.

Referring to Figure 4A, with continuing reference to Figures 1-3, the tessellated model 36 may establish a user interface 48. The user interface 48 may be suitable for a lightweight viewer, such as lightweight viewer 46, which may display the tessellated model 36 according to the API 50. Figure 4A discloses an implementation of the lightweight viewer 46. The tessellated model 36 may include the tessellated geometry, information associated or presented with the tessellated geometry, and/or information utilized to establish the user interface 48.

The user interface 48 may be arranged in a manner that may declutter secondary information associated with the design geometry 33 such that a main viewing area may be relatively large. The user interface 48 may include one or more display windows 52 which may serve to divide the user interface 48 into different areas. In the implementation of Figure 3, the display windows 52 may include a first (e.g., main) viewing window 52-1, a second (e.g., navigation) window 52-2, a third (e.g., preview) window 52-3, a fourth (e.g., information) window 52-4, and a fifth (e.g., information) window 52-5. The information window 52-4 may be a dynamic information window that may dynamically display information. The information may be contextual depending on what view the user may select. The information window 52-5 may be a persistent information window, which may always be visible in the user interface 48 and may display information without change. The information may include the title, part number, document number, etc. that may uniquely identify the design. Although the user interface 48 is shown with five display windows 52, it should be understood that fewer or more than five display windows 52 may be utilized in accordance with the teachings disclosed herein. The viewing window 52-1 and/or preview window 52-3 may be operable to display one or more depictions of the geometry 33. The windows 52-2, 52-4 and/or 52-5 may be operable to display various information relating to the geometry 33 and/or other aspects of the design. In implementations, the window(s) 52 may be operable to display information associated with one or more attributes specified in the lightweight file 37. Attribute(s) may be associated with the geometry 33 and/or depictions (e.g., views) of the geometry 33, but some attribute(s) may be specified at a global (e.g., file) level. The attributes may be specified in a header of the file 37.

The modeling environment 28 may be operable to generate one or more geometric objects 54. The modeling environment 28 may be operable to generate a tessellated model 36 that includes the geometric object(s) 54. The geometric objects 54 may establish a tessellation of geometry 33 (see, e.g., Figure 2). The viewing window 52-1, preview window 52-3 and/or another display window 52 may be operable to display geometry 33 established by one or more geometric objects 54 of the tessellated model 36. The geometric objects 54 may be operable to display various depictions of the tessellation of the geometry 33 in the viewing window 52-1 and/or another window 52 of the user interface 48. Each of the geometric objects 54 may be associated with one or more graphics that may depict a geometry of the design. The depictions may include two-dimensional and/or three-dimensional views of the geometry 33 and may include solids, wireframes, transparencies, etc. The modeling environment 28 may be operable to store the tessellated models 36 in one or more lightweight files 37, which may be readable by the lightweight viewer 46. In implementations, the file(s) 37 may exclude any CAD models 32, including any CAD models 32 utilized to establish, or that may otherwise be related to, tessellated model(s) 36 of the respective geometry 33. The modeling environment 28 may be operable to store code (e.g., scripts, function calls, etc.) in the lightweight file 37 that may be operable to cause one or more functions associated with the tessellated model 36 to execute in the lightweight viewer 46, including any of the functions disclosed herein.

The modeling environment 28 may be operable to generate one or more view objects 56. Each of the view objects 56 may be associated with respective depictions of the geometric object(s) 54 associated with the geometry 33. The view objects 56 may be associated with the navigation window 52-2 and/or another window 52 of the user interface 48. The navigation window 52-2 may be operable to display one or more of the view objects 56, which may be depicted in a list. The viewing window 52-1 may be operable to display the depiction in response to user interaction or selection of the respective view object 56.

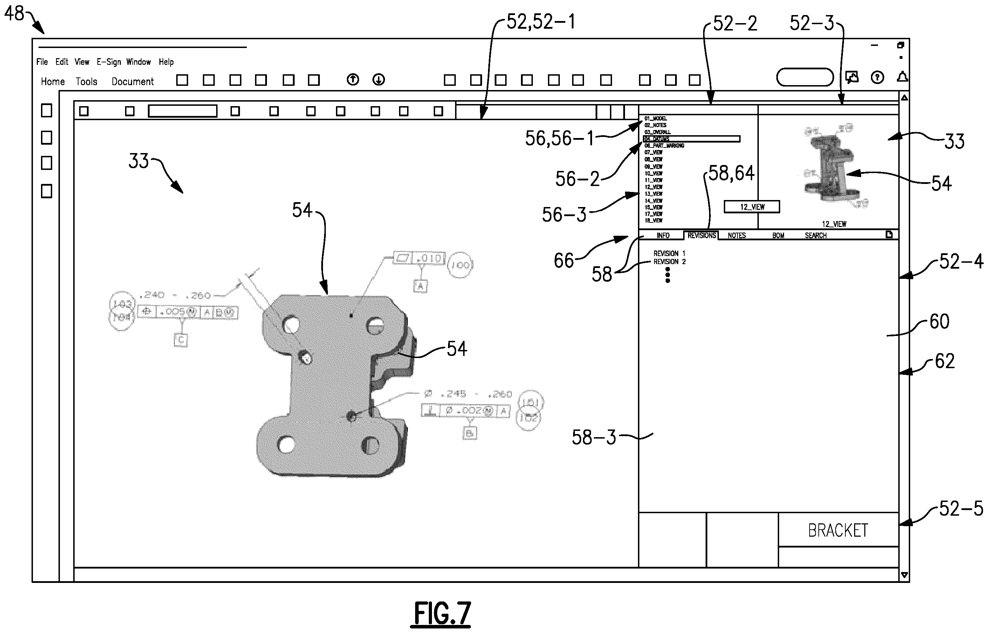

In implementations, the view objects 56 may include first, second, and third view objects 56-1 to 56-3. The view object 56-1 may be associated with an overall representation of the geometry 33. The second view object 56-2 may be associated with another depiction of the geometry 33, such as a depiction including one or more datums or other annotations (see, e.g., Figure 7). The viewing window 52-1 may be operable to display the depiction of the geometry 33 in response to selection of the respective view object 56. The preview window 52-3 may be operable to display a depiction of the geometry 33 associated with the respective view object 56 in response to user interaction. In implementations, a user may interact with the user interface 48 by positioning a cursor on or otherwise adjacent to the view object 56 to cause the preview window 52-3 to display the respective depiction (e.g., preview) of the geometry 33, which may be displayed in the viewing window 52-1 in response to selection of the view object 56 (e.g., mouse click).

The information window 52-4 may be operable to display information in the user interface 48. The information may be generic and/or may be associated with the geometry 33. The information window 52-4 may be dynamically linked to one or more of the geometric objects 54 such that selection of the geometric object 54 may cause information to update in the information window 52-4.

The modeling environment 28 may be operable to generate one or more content objects 58. The tessellated model(s) 36 may include the content object(s) 58. The content object(s) 58 may be operable to establish the information window 52-4. The content objects 58 may be operable to selectively display information associated with the tessellated model 36 and/or respective geometry 33 in a common display region 62 and/or another portion of the user interface 48. The content objects 58 may be operable to establish the information window 52-4 such that the common display region 62 may be spaced apart from, but may be concurrently displayed with, the viewing window 52-1 in response to opening the tessellated model 36 in the lightweight viewer 46.

The content objects 58 may be assigned various information, including information associated with the tessellated model 36. The information may be assigned to content fields 59 associated with the respective content objects 58 (Figure 3). In implementations, the content fields 59 may be associated with information specified in a data structure (e.g., template) readable by the lightweight viewer 46. The lightweight file 37 may store the information in the data structure according to the API 50. In other implementations, the information may be stored directly in the respective content fields 59. The content field 59 may be a portion of the content object 58 or may be another object linked to the content object 58. Various techniques may be utilized to define the information associated with the content fields 59, including various data types or structures such as character, string, integer, boolean, array, date, time, etc. In implementations, the content fields 59 may contain code (e.g., script), which may be executable by the API 50 and/or lightweight viewer 46. The information assigned to the content objects 58 may be the same or may at least partially differ from information assigned to other content objects 58. The information may be associated with various details of the organization responsible for the CAD model 32. The information may include a revision history of the CAD model 32, various notes or statements associated with the CAD model 32, a bill of material (BOM) associated with component(s) represented by the geometry 33, etc. The content objects 58 may be operable to display information assigned to the respective content field 59 in respective portions of the information window 52-4.

The modeling environment 28 may be operable to generate one or more content layers 60. The layers 60 may be respective objects of the tessellated model 36. Each content object 58 may be associated with one or more of the layers 60. The content objects 58 may be assigned (e.g., occupy) the same view location in the user interface 48 but may be assigned to different layers 60 of the model 36. At least some of the layers 60 may occupy the common display region 62 of the user interface 48. The layers 60 may be dimensioned to at least partially, substantially, or completely overlap with each other in the common display region 62. The content objects 58 may be operable to selectively display information associated with the tessellated model 36 in response to user interaction with or selection of the respective content object 58 such that the respective layer 60 may be activated, but a remainder of the layers 60 may be deactivated in the common display region 62.

Various techniques may be utilized to establish the layers 60 in the user interface 48. The modeling environment 28 may be operable to establish a tabbed interface 66. The tabbed interface 66 may be utilized to display information relating to the geometry 33 and/or other aspects of the tessellated model 36. Each viewable tab of the tabbed interface 66 may be established by at least two objects. One object may be associated with the tab name (e.g., tab object 64) and another object may be associated with the respective information area (e.g., content object 58). The user may interact with a control object 71 in the user interface 48 to open a separate document containing a full listing of applicable tabs. Prior systems may include a model tree window having one or more tabs for displaying various information, such as a model tree, model views, product manufacturing information (PMI), etc., specified in a data stack. However, the model tree window may be provided by the application itself independent of any particular lightweight file, instead of being established by objects stored in the lightweight file.

The modeling environment 28 may be operable to generate one or more tab objects 64. The tessellated model 36 may include the tab objects 64. The information window 52-4 may be established by the tab object(s) 64 and control objects 58. The tab objects 64 may be operable to graphically depict the tabbed interface 66 in the information window 52-4 or another portion of the user interface 48. The tab objects 64 may be arranged in an array to graphically depict the tabbed interface 66. The tab objects 64 may be arranged in a row or may otherwise be offset from each other. The tabbed interface 66 may be directly adjacent to the common display region 62. The tab objects 64 may be associated with one or more content objects 58. Each tab object 64 may be associated with a respective layer 60 and one or more content objects 58 assigned to the layer 60. Each of the layers 60 and/or respective tab objects 64 may be associated with an activated state and a deactivated state. The tab objects 64 may be operable to graphically depict the current states in the user interface 48. The layers 60 may be made visible or invisible based on selection of the tab object 64. One layer 60 may be selectively visible at a time. Each of the tab objects 64 may be operable to selectively activate the layer 60 of the respective content object(s) 58 and deactivate a remainder of the layers 60 associated with the information window 52-4 in response to user interaction or other selection of the respective tab object 64.

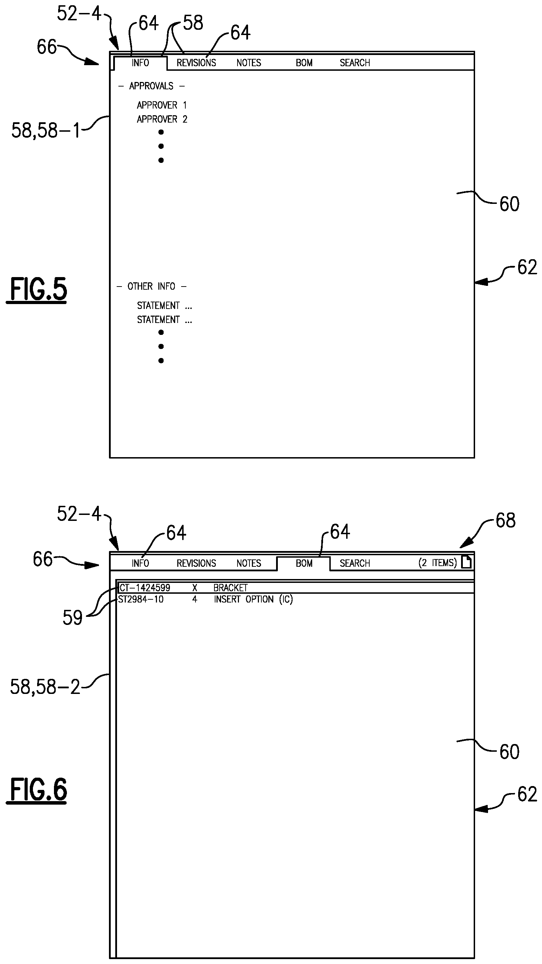

In the implementation of Figure 5, the content objects 58 may include a first content object 58-1. The content object 58-1 may be associated with various information relating to personnel(s) and/or organization(s) assigned to designing, reviewing, manufacturing, etc., of the component(s), assembly or system.

The modeling environment 28 may be operable to dynamically link one or more of the content objects 58 to one or more of the view objects 56 such that contents of a list or other information assigned to the content objects 58 may update in response to user interaction with or selection of the respective view objects 56. One or more of the content objects 58 may be dynamically linked to one or more of the view objects 56 such that the content fields 59 and/or other information assigned to the respective content objects 58 may update in response to selection of the respective view object 56. In the implementation of Figure 6, the content objects 58 may include a second content object 58-2. The second content object 58-2 may be operable to display a bill of material (BOM) associated with the design. The content fields 59 of the associated content object 58-2 may be depicted graphically as a list. In implementations, the list may be an interactive list. The content fields 59 associated with the respective content object 58-2 may be dynamically linked to one or more of the respective view objects 56. Selection of a respective view object 56 from the navigation window 52-2 may cause the interactive list to update such that content of the content fields 59 associated with the respective content object 58 may be displayed in the common display region 62 according to the selected view object 56. The content displayed in the list may include unique identifiers (e.g., part numbers, names, descriptions, etc.) assigned to the associated geometric objects 54 and related information (see, e.g., Figures 4A-4B). In implementations, the content object 58-2 may include a content field associated with each of the respective geometric objects 54. The content object 58-2 may be operable to selective display of content in the content fields 59 in response to selection of the respective view object 56.

The information displayed in the information window 52-4 may include one or more statements. The statements may be established by one or more respective content fields 59. The content objects 58 may be operable to establish a list associated with a quantity of the statements assigned to the content fields 59 of the respective content object 58.

Each tab may be associated with a counter. The content objects 58 may be associated with a counter object 68 that may establish the counter. The counter object 68 may be arranged adjacent to the common display region 62. The counter object 68 may be operable to indicate a quantity of the statements assigned to the respective content objects 58 that may be currently indicated in the list.

Referring back to Figures 4A-4B, each tab may be associated with a control object 70 for interacting with information in the tabbed interface 66. The user may interact with the control object 70 to view the associated information, which may be useful in decluttering the information window 52-4 by reducing the size of the information area. One or more of the content objects 58 may be associated with the control object 70. The control object 70 may be adjacent to the common display region 62. The tessellated model 36 may include the control object 70. The control object 70 may be operable to cause a visible portion of the activated layer 60 to vary in response to user interaction. The control object 70 may be a scroll bar object. The scroll bar object 70 may be moveable in direction D1. The scroll bar object 70 may be manipulated by the user to view information displayed in the common display region 62. The counter object 68 may indicate that related content is available, which may be useful by suggesting that the user may interact with the scroll bar object 70 to view the additional information.

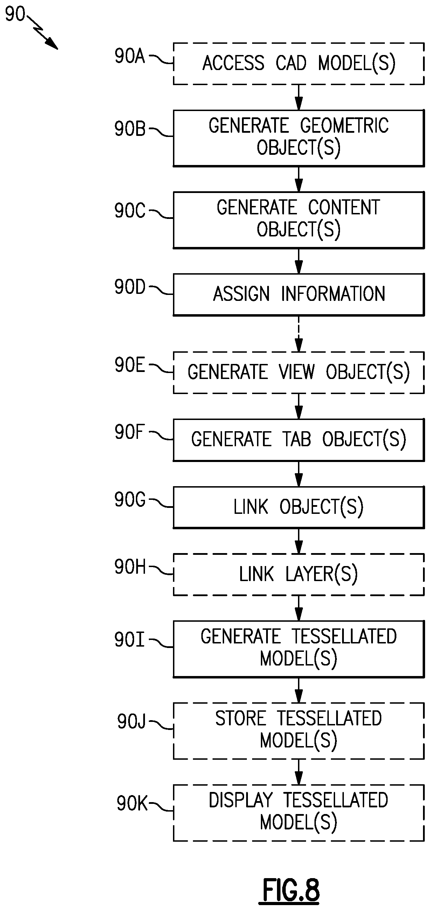

Figure 8 discloses a method of establishing and/or interacting with a tessellated model in a flow chart 90 according to an implementation. The method 90 may be utilized to generate one or more tessellated models associated with design geometry. The geometry may be defined in one or more associated CAD models. The tessellated models may exclude any CAD models associated with the geometry. Fewer or additional steps than are recited below could be performed within the scope of this disclosure, and the recited order of steps is not intended to limit this disclosure. The modeling environment 28 may be programmed with logic for performing method 90. Reference is made to the system 20.

Referring to Figure 1, with continuing reference to Figure 8, one or more CAD models 32 may be accessed at step 90A. The CAD model 32 may be associated with respective geometry 33. A CAD system 30 may be utilized to define the geometry 33 in the CAD model 32.

Referring to Figures 2-4A, with continuing reference to Figures 1 and 8, one or more geometric objects 54 may be generated at step 90B. The geometric objects 54 may establish a tessellation of the geometry 33, which may be stored in a tessellated model 36. The geometric objects 54 may be operable to display the tessellation of geometry 33 in the viewing window 52-1 and/or another display window 52 of the user interface 48.

Referring to Figures 3-4, with continuing reference to Figures 1 and 8, one or more content objects 58 may be generated at step 90C. The content objects 58 may be operable to establish the information window 52-4 of the user interface 48. Step 90C may include associating the content objects 58 with respective layers 60 that may occupy the common display region 62 of the user interface 48. The content objects 58 may be operable to establish the information window 52-4 such that the common display region 62 may be spaced apart from, but may be concurrently displayed with, the viewing window 52-1 in the user interface 48.

At step 90D, information associated with the geometry 33 and/or other information may be assigned to the content objects 58. In implementations, the information may be stored in one or more content fields 59. The information may be displayed utilizing any techniques disclosed herein. The content objects 58 may be operable to selectively display the respective information in the common display region 62 of the user interface 48.

At step 90E, one or more view objects 56 may be generated. The view objects 56 may be associated with respective depictions of the geometry 33.

At step 90F, one or more tab objects 64 may be generated. The tab objects 64 may be operable to depict the tabbed interface 66 in the information window 52-4. Each tab object 64 may be associated with one or more of the content objects 58.

At step 90G, one or more of the objects may be linked to other object(s) of the tessellated model 36, including any of the objects disclosed herein. The objects may include the geometric objects 54, view objects 56, content objects 58, tab objects 64, counter objects 68, and/or control objects 70.

At step 90H, one or more of the objects may be linked to one or more respective layers 60. Each of the tab objects 64 may be operable to selectively activate the layer 60 of the respective content object(s) 58 and deactivate the remainder of the layers 60 associated with the information window 52-4 and/or another portion of the user interface 48 in response to user interaction with or selection of the respective tab object 64.

At step 901, one or more tessellated models 36 may be generated. The tessellated models 36 may be generated utilizing any of the techniques disclosed herein. The tessellated model 36 may include any of the objects and features disclosed herein, such as the geometric objects 54, content objects 58, layers 60, tab objects 64, counter objects 68, and/or control objects 70.

Linking the objects at step 90G may include dynamically linking one or more of the content objects 58 to one or more of the view objects 56 such that the information assigned to the respective content object 58 may update in response to user action with the respective view object 56. In implementations, the content objects 58 may be operable to display a list of the information which may be dynamically updated in response to selection of the view object 56.

At step 90J, the tessellated model(s) 36 may be stored in one or more lightweight files 37. The files 37 may exclude the CAD model(s) 32 associated with the respective geometry 33.

At step 90K, the tessellated model(s) 36 may be displayed in a lightweight viewer 46. Step 90K may include establishing the user interface 48 in the display according to the objects of the tessellated model 36. The tessellated model 36 may cause the lightweight viewer 46 to execute code including one or more scripts, which may be specified in the content fields 59 of the content objects 58 or may otherwise be embedded in the tessellated model 36. Step 90K may include displaying one or more depictions of the geometry 33 in the display window(s) 52.

The systems and methods disclosed herein may be utilized to generate tessellated models associated with geometry of one or more components, assemblies and/or systems. The tessellated models may be stored in relatively compact files, which may be readable by a lightweight viewer provided to users who may not have access to a CAD system. The systems and methods disclosed herein may be utilized to establish a tabbed interface. The tabbed interface may be utilized to reserve a relatively larger portion of the user interface for viewing geometry associated with the tessellated models and model-based definition (MBD). The disclosed techniques may be utilized to declutter the amount of information simultaneously presented to the user.

Although the different examples have the specific components shown in the illustrations, embodiments of this disclosure are not limited to those particular combinations. It is possible to use some of the components or features from one of the examples in combination with features or components from another one of the examples.

Although particular step sequences are shown, described, and claimed, it should be understood that steps may be performed in any order, separated or combined unless otherwise indicated and will still benefit from the present disclosure.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A user interface (48) for a lightweight viewer (46) comprising:
a viewing window (52-1) operable to display geometry (33) established by one or more geometric objects (54) of a tessellated model (36); and
an information window (52-4) established by a plurality of content objects (58) of the tessellated model, the content objects associated with respective layers (60) of the tessellated model that occupy a common display region (62), the content objects operable to selectively display information associated with the tessellated model in response to user interaction with the respective content object such that the respective layer is activated but a remainder of the layers are deactivated in the common display region.

2. The user interface as recited in claim 1, wherein the common display region is spaced apart from, but concurrently displayed with, the viewing window in response to opening the tessellated model.

3. The user interface as recited in claim 1, wherein the information window is established by a plurality of tab objects (64) of the tessellated model, the tab objects are arranged in an array to depict a tabbed interface (66), the tab objects are associated with respective ones of the content objects, and each of the tab objects is operable to selectively activate the layer of the respective content object and deactivate the remainder of the layers in response to user interaction with the respective tab object; and, optionally,
wherein the array is directly adjacent to the common display region.

4. The user interface as recited in claim 1, wherein one or more of the content objects is associated with a scroll bar object (70) adjacent to the common display region.

5. The user interface as recited in claim 4, wherein the scroll bar object is operable to cause a visible portion of the activated layer to vary in response to user interaction; and, optionally,
wherein the information includes one or more statements, the content objects are associated with a counter object (68), and the counter object is operable to indicate a quantity of the one or more statements assigned to the respective content object.

6. The user interface as recited in claim 1, further comprising:
a navigation window (52-2) operable to display one or more view objects (56, 56-1, 56-2, 56-3), each of the one or more view objects associated with a respective depiction of the one or more geometric objects;
wherein the viewing window is operable to display the depiction in response to selection of the respective view object; and
one or more of the content objects is dynamically linked to one or more of the view objects such that the information assigned to the respective content object updates in response to selection of the respective view object.

7. The user interface as recited in claim 1, wherein the tessellated model excludes any CAD model associated with the geometry.

8. A system (20) for generating a tessellated model comprising:
a computing device (22, 38) including one or more processors (42) coupled to memory (44);
wherein the computing device is operable to execute a modeling environment (28), and the modeling environment is operable to:
access a computer-aided design (CAD) model (32) associated with geometry (33);
generate one or more geometric objects (54) that establish a tessellation of the geometry;
generate a plurality of content objects (58);
generate a tessellated model (36) including the one or more geometric objects and the content objects;
wherein the one or more geometric objects are operable to display the tessellation of the geometry in a viewing window (52-1) of a user interface (48); and
wherein the content objects are operable to establish an information window (52-4) of the user interface, the content objects are associated with respective layers (60) of the tessellated model that occupy a common display region (62) of the user interface, and the content objects are operable to selectively display information associated with the tessellated model in the common display region.

9. The system as recited in claim 8, wherein the content objects are operable to establish the information window such that the common display region is spaced apart from, but concurrently displayed with, the viewing window in response to opening the tessellated model in a lightweight viewer (46).

10. The system as recited in claim 8, wherein the modeling environment is operable to:
generate a plurality of tab objects (64);
wherein the tessellated model includes the tab objects; and
wherein the tab objects are operable to depict a tabbed interface (66) in the information window, the tab objects are associated with respective ones of the content objects, and each of the tab objects is operable to selectively activate the layer of the respective content object and deactivate a remainder of the layers in response to user interaction with the tab object; or
wherein the modeling environment is operable to:
generate one or more view objects (56) associated with a navigation window of the user interface, wherein each of the one or more view objects is associated with a respective depiction of the one or more geometric objects, and the viewing window is operable to display the depiction in response to user interaction with the respective view object;
dynamically link one or more of the content objects to one or more of the view objects such that the information assigned to the one or more content objects updates in response to user interaction with the respective view object; and
wherein the tessellated model includes the one or more view objects; or wherein the modeling environment is operable to:
store the tessellated model in a file (37) readable by a lightweight viewer (46), the file excluding the CAD model; and, optionally,
wherein the modeling environment is operable to:
store code in the file that is operable to cause one or more functions associated with the tessellated model to execute in the lightweight viewer.

11. A method (90) of establishing a tessellated model (36) comprising:
generating (90B) one or more geometric objects that establish a tessellation of geometry stored in a computer-aided design (CAD) model, wherein the one or more geometric objects are operable to display the tessellation of the geometry in a viewing window of a user interface;
generating (90C) a plurality of content objects, wherein the content objects are operable to establish an information window of the user interface, and the content objects are associated with respective layers that occupy a common display region of the user interface;
assigning information (90D) associated with the geometry to the content objects, wherein the content objects are operable to selectively display the respective information in the common display region; and
generating (90I) a tessellated model including the one or more geometric objects and the content objects.

12. The method as recited in claim 11, further comprising:
generating (90F) a plurality of tab objects, wherein the tab objects are operable to depict a tabbed interface in the information window, the tab objects are associated with respective ones of the content objects, and each of the tab objects is operable to selectively activate the layer of the respective content object and deactivate a remainder of the layers in response to user interaction with the respective tab object; and
wherein the step of generating the tessellated model occurs such that the tessellated model includes the tab objects.

13. The method as recited in claim 12, wherein the content objects are operable to establish the information window such that the common display region is spaced apart from, but concurrently displayed with, the viewing window.

14. The method as recited in claim 11, further comprising:
dynamically linking (90G) one or more of the content objects to one or more view objects such that the information assigned to the respective content object updates in response to user interaction with the respective view object, wherein the one or more view objects are associated with respective depictions of the one or more geometric objects in the viewing window.

15. The method as recited in claim 11, further comprising:
storing (90J) the tessellated model in at least one file that excludes the CAD model; and, optionally,
displaying (90K) the tessellated model in a lightweight viewer.
